**Europäisches Patentamt**

**European Patent Office**

**Office européen des brevets**

(19)

(11) Numéro de publication: **0 004 292**
**A2**

# (12) DEMANDE DE BREVET EUROPEEN

(21) Numéro de dépôt: **79100546.5**

(22) Date de dépôt: **23.02.79**

(51) Int. Cl.²: **H 01 L 21/00, H 01 L 29/10,
H 01 L 29/72**

(30) Priorité: **27.03.78 US 890115**

(43) Date de publication de la demande: **03.10.79**
**Bulletin 79/20**

(84) Etats contractants désignés: **DE FR GB**

(71) Demandeur: **International Business Machines
Corporation, Armonk, N.Y. 10504 (US)**

(72) Inventeur: **Ning, Tak Hung, 1720 Maxwell Drive,
Yorktown Heights New York 10598 (US)**
Inventeur: **Yu, Hwa-Nien, 2849 Hickory Sreet, Yorktown
Heights New York 10598 (US)**

(74) Mandataire: **Klein, Daniel, COMPAGNIE IBM FRANCE
Département de Propriété Industrielle, F-06610 La
Gaude (FR)**

(54) **Procédé de fabrication d'un transistor bipolaire de type MESA présentant des régions d'émetteur et de base auto-alignées.**

(57) Ce transistor est réalisé à partir d'une structure classique comportant un substrat (21), une région de sous-collecteur (22) associée à une région de traversée de collecteur (24), une couche épitaxiale (20) servant de région de collecteur et une couche de base (26) et des murs d'isolement (23). Dans un mode préféré on forme une couche d'émetteur (27) sur la couche de base. Puis une couche de masquage (28) est formée sur la couche d'émetteur, elle définit une ouverture autour de la région destinée à constituer l'émetteur. Les parties exposées de la structure sont attaquées ce qui définit avec précision la région d'émetteur (27), et la région de base (26). On forme alors par implantation ionique la région de contact de base (32). Les régions d'émetteur, de base et de contact de base sont donc auto-alignées. La structure est passivée par les régions d'oxyde encastré (33). On forme enfin les contacts ohmiques nécessaires. Ce procédé permet l'obtention de transistors très rapides et à grande densité d'intégration utiles dans les applications aux calculateurs.

1

## PROCEDE DE FABRICATION D'UN TRANSISTOR BIPOLAIRE DE TYPE MESA PRESENTANT DES REGIONS D'EMETTEUR ET DE BASE AUTO-ALIGNEES

## Description

La présente invention concerne un procédé de fabrication d'un transistor bipolaire de type Mesa présentant des régions d'émetteur et de base alignées (ou centrées), et le transistor en résultant.

## Domaine Technique

Avec les transistors bipolaires de dimensions réduites la recherche de la symétrie du courant circulant de l'émetteur vers la base a une influence sur la surface affectée à chaque dispositif. Dans les transistors, dans lesquels le contact de base peut être situé à proximité immédiate de la région d'émetteur, une diminution substantielle de la résistance de base et de la capacité de collecteur peut être obtenue. Il est reconnu qu'une bonne symétrie du courant circulant de l'émetteur vers la base et une disposition très rapprochée des contacts de base et d'émetteur, permettent d'obtenir une vitesse de commutation plus élevée.

2

Toutefois, on se trouvait jusqu'ici en présence d'une limitation en ce sens que, des techniques de fabrication de circuits intégrés étant employées pour séparer les différents dispositifs, tout procédé de mise en place des contacts de base en fonction de la position occupée par les contacts d'émetteur doit nécessairement être compatible avec les diverses étapes du traitement employé.

## Etat de la technique

Dans l'art antérieur, les transistors bipolaires réalisés au moyen du procédé planar dans un élément semi-conducteur comportent des contacts alignés avec des parties de cet élément et, qui sont délimitées par isolement. Ces structures étaient réalisées jusqu'à présent en effectuant des opérations de formation de région de contact et de formation de régions d'isolement au travers d'ouvertures pratiquées dans un photorésist ou résine photosensible, mais toute modification de la position des contacts de base devait être compatible avec les autres étapes du procédé, et la position du contact de base était choisie davantage pour assouplir les tolérances afférentes à la surface requise que pour assurer la symétrie de la circulation du courant.

## Exposé de l'invention

La présente invention concerne dans son aspect le plus général un procédé de fabrication d'une région de contact de base d'un transistor bipolaire de type Mesa dans un substrat semi-conducteur avec des régions base et émetteur auto-alignées, caractérisé en ce que la couche de masquage qui définit la région d'émetteur

3

sert également à délimiter la région de contact de base et la région de base.

Elle concerne plus particulièrement un premier procédé de fabrication d'un transistor bipolaire de type Mesa présentant des régions émetteur et base auto-alignées qui comporte les étapes suivantes:

a) élaboration d'un substrat semi-conducteur comportant un support d'un premier type de conductivité (21), une région de sous-collecteur (22), une région de traversée de sous-collecteur (24), une couche épitaxiale d'un type de conductivité opposé (20) formant collecteur, des éléments d'isolement (23) définissant une poche isolée, une première couche dite de base (26) du premier type de conductivité,

b) formation d'une seconde couche du second type de résistivité (27) dite couche d'émetteur dans la couche de base,

c) formation d'une couche de masquage (28) selon une configuration désirée au-dessus de la couche d'émetteur, la partie sous-jacente de celle-ci définissant la région d'émetteur,

d) attaque des couches de base et d'émetteur à travers les ouvertures de la couche de masquage pour assurer la forme du type Mesa, la partie restante de la première couche constituant la région d'émetteur,

e) introduction d'un dopant du premier type de

4

conductivité à travers ces ouvertures pour former la région de contact de base (32), qui est délimitée par ladite couche de masquage, cette étape délimite simultanément la région base,

f)    formation de régions d'isolement sur les portions exposées de la région de contact de base, de la région base et de la région émetteur, et

g)    formation des contacts électriques avec les régions émetteur, contact de base, et traversée de collecteur.

Elle concerne également un deuxième procédé de fabrication d'un transistor bipolaire de type Mesa présentant des régions émetteur et base auto-alignées qui comporte les étapes suivantes:

a)    élaboration d'un substrat semi-conducteur comportant un support d'un premier type de conductivité (21), une région de sous-collecteur (22), une région de traversée de sous-collecteur (24), une couche épitaxiale d'un type de conductivité opposé (20) formant collecteur, des éléments d'isolement (23) définissant une poche isolée, une première couche dite de base (26) du premier type de conductivité,

b)    formation d'une couche de masquage (40) en oxyde dopé par une impureté du deuxième type de conductivité selon une configuration désirée au-dessus de la couche de base,

c)   introduction d'un dopant du premier type de conductivité à travers les ouvertures de la couche de masquage pour former la région de contact de base (45) qui est délimitée par la couche de masquage, cette étape délimite simultanément la région base,

d)   attaque des parties exposées des régions de contact de base et de base,

e)   formation des régions d'isolement (46) sur les parties exposées des régions de contact de base et de base et simultanément diffusion des impuretés de la couche de masquage dans la région base pour former une région émetteur (47),

f)   formation des contacts électriques avec les régions émetteur, contact de base, et traversée de collecteur.

Ces procédés ont l'avantage d'être parfaitement compatibles avec les technologies de fabrication des circuits intégrés à semi-conducteur et de conduire à des transistors bipolaires de type Mesa, à régions émetteur et base auto-alignées, à injection de courant symétrique et à vitesse élevée.

D'autres objets, caractéristiques et avantages de la présente invention ressortiront mieux de l'exposé qui suit, fait en référence aux dessins annexés à ce texte, qui représentent un mode de réalisation préféré de celle-ci.

6

## Brève description des figures

La figure 1 représente deux des étapes du procédé de fabrication d'un transistor bipolaire présentant des régions d'émetteur et de base alignées.

Les figures 2 et 3 représentent schématiquement une vue en coupe d'un transistor bipolaire de type Mesa à régions d'émetteur et de base alignées, obtenu conformément aux étapes de fabrication montrées sur la figure 1.

Les figures 4 et 5 représentent respectivement le substrat semi-conducteur typique initial et ce substrat, (dit substrat initial) après qu'il ait été muni des régions d'isolement et de contact de traversée de collecteur.

Les figures 6 à 10 représentent les modifications successives du substrat initial qui interviennent lors de la mise en oeuvre du procédé de la présente invention et qui permettent d'obtenir un transistor bipolaire de type Mesa à régions d'émetteur et de base alignées caractérisé en ce que l'émetteur fait partie d'une région non éliminée d'une couche initiale.

Les figures 11 à 15 représentent les modifications successives du substrat initial qui interviennent lors de la mise en oeuvre du procédé de la présente invention et qui permettent d'obtenir un transistor bipolaire de type Mesa à régions d'émetteur et de base alignées caractérisé en ce que l'émetteur est formé à partir d'impuretés présentes dans l'oxyde.

7
## Description détaillée des modes de réalisation

Le transistor à régions d'émetteur et de phase alignées de la présente invention est obtenu en réalisant une ouverture dans une couche de masquage de manière à exposer la portion de cristal semi-conducteur qui entoure l'émetteur. La conductivité de cette portion est ensuite rendue identique, à travers cette ouverture, à celle de la région de base du transistor, avec une résistivité désirée. Des contacts électriques pourront ensuite être établis avec la région de base présentant ce type de conductivité. Dans la structure finalement obtenue, le courant circule de façon symétrique de l'émetteur vers la base en raison du fait que cette dernière se trouve à proximité immédiate de l'émetteur et entoure celui-ci.

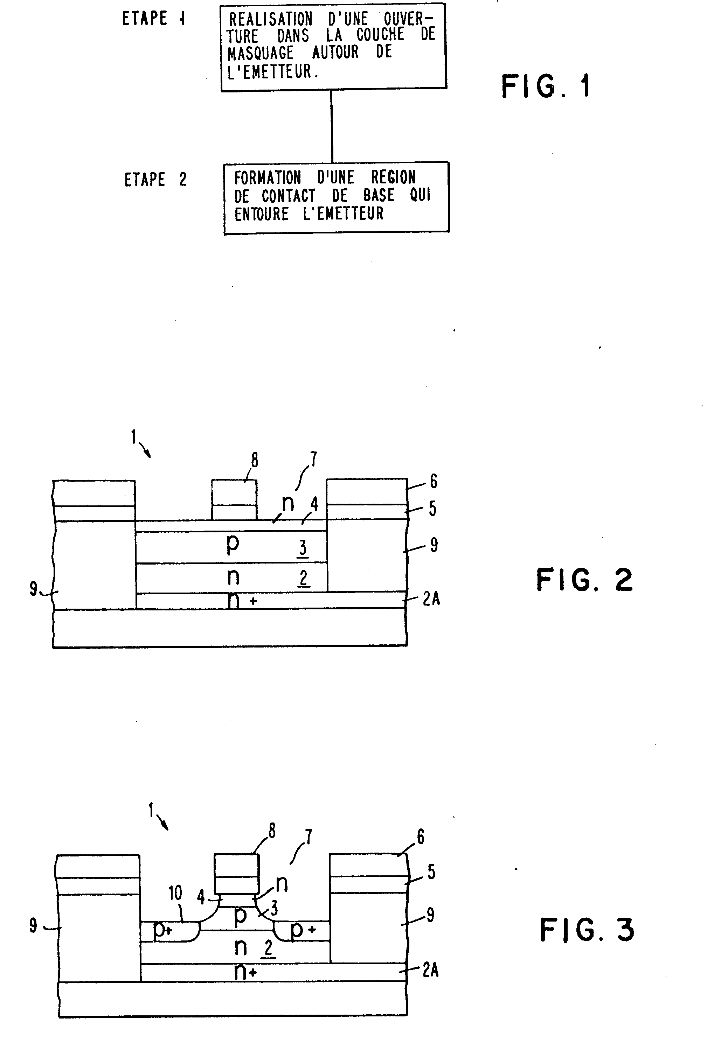

On a représenté sur la figure 1 un organigramme montrant deux étapes qui permettent de réaliser le transistor bipolaire de la présente invention à l'aide de tout procédé de fabrication classique. Pendant l'étape 1, une ouverture est réalisée dans la couche de masquage qui entoure et recouvre l'émetteur du futur dispositif. Pendant l'étape 2, on forme une région de contact de base présentant le même type de conductivité que celui de la région de base, à travers ladite ouverture.

La structure que les étapes de la figure 1 permettent d'obtenir est représentée sur les figures 2 et 3. La figure 2 représente un transistor 1, de préférence en silicium, qui comporte une région de collecteur 2 de résistivité n et une région de sous-collecteur de faible résistivité 2A de type n+. Il comporte également

8

une région ou couche de base 3 de type p, qui est reliée à la région de collecteur 2 par une jonction p-n et une couche ou région d'émetteur 4 de type n reliée à la région 3 par une jonction p-n. La surface correspondant à la région d'émetteur dans la couche 4 est recouverte d'une couche de masquage de passivation constituée par une région d'oxyde 5 elle-même recouverte par exemple d'un photorésist 6. Une ouverture 7, est réalisée conformément aux enseignements de l'étape 1 de la figure 1, jusqu'à la surface de la région 4 et entoure la région 8 qui définira l'émetteur. En pratique, la structure obtenue fait généralement partie d'un groupe de dispositifs fabriqués dans un même élément semi-conducteur, et des régions isolantes 9 permettront de séparer les différents dispositifs.

Sur la figure 3, la modification du type de conductivité d'une partie du cristal à travers l'ouverture 7, est réalisée conformément aux enseignements de l'étape 2 de la figure 1. On obtient ainsi une région de contact 10 qui présente une conductivité élevée p+ du même type que celle de la région de base 3, en outre elle entoure complètement l'émetteur. Une étape de décapage est ensuite prévue pour retirer le matériau autour de l'émetteur et ne laisser que la région 4 de type n. Cette dernière présente un décapage latéral par rapport à la couche d'oxyde 5 qui sert de couche de masquage. La portion de la couche 4 de type n qui demeure fera fonction de région émetteur.

Ainsi qu'il est clair pour l'homme de l'art, la technique d'alignement de la présente invention est indépendante de la technique d'isolement qui est utilisée en relation avec le procédé. Bien que, sur les figures 2 et 3, cet isolement soit simplement représenté par un élément 9, cet isolement peut être constitué par de l'oxyde encastré formé en décapant une tranchée et en remplissant celle-ci par de l'oxyde, ou par une diffusion de type p+ (pour le type de conductivité représenté), ou encore par une combinaison de cette dernière diffusion et de l'oxyde encastré.

La région 10 (figure 3) peut être réalisée par décapage du silicium suivi d'une étape d'introduction d'impuretés: implantation ou diffusion d'impuretés appropriées (exemple le bore). Il en résulte une structure de type Mesa bien connue.

Les dimensions exactes de la séparation entre la région d'émetteur 4 et la région de base 3 sont déterminées par les dimensions de la région 8 et par le décapage latéral effectué au-dessous de la couche 5.

Ainsi que le comprendra l'homme de l'art, la présente invention permet de commander immédiatement une vaste gamme de caractéristiques et de performance grâce à l'introduction des étapes du procédé de l'invention; aux différents matériaux de masquage utilisés aux fins de la lithographie et aux vitesses de décapage différentes. Si bien que finalement, grâce au décapage latéral et à la l'ajustement de la distance entre la région d'émetteur 4 et la région de contact 10, la structure présente outre une symétrie de la circulation du courant, un gain en courant élevé, des performances en tension élevées et occupe un minimum de place.

Afin de faciliter la mise en oeuvre de la présente invention, deux procédés complets seront illustrés ci-après étant donné qu'en pratique les dispositifs feront

10

en principe partie intégrante d'un ensemble réalisé dans un même substrat semi-conducteur, et que les dispositifs appartenant à ce groupe seront séparés, par des techniques d'isolement qui exigent un nombre important d'étapes de fabrication.

Dans les deux procédés, le matériau de départ est un substrat semi-conducteur comportant une couche épitaxiale dans laquelle le dispositif sera formé. Au-dessous de cette région épitaxiale se trouvent des régions présentant une faible résistivité et qui feront fonction de sous-collecteurs enterrés pour les différents dispositifs.

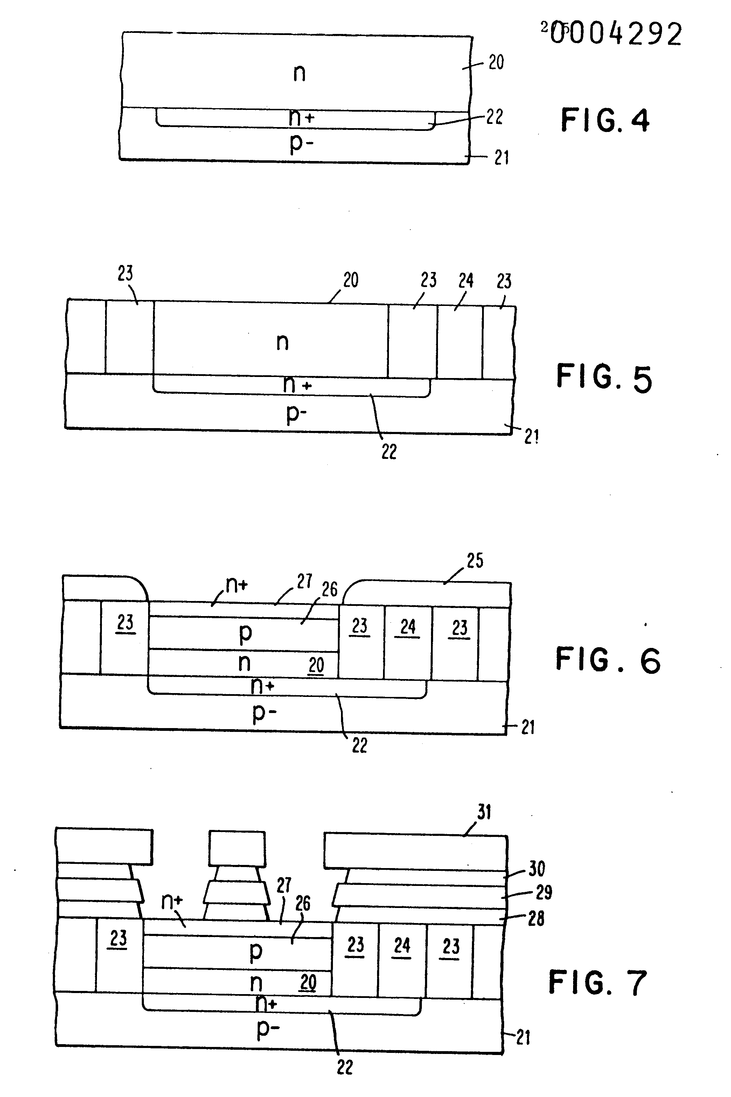

On a représenté sur les figures 4 et 5 un élément semi-conducteur de départ typique. On a fait croître sur un substrat ou support 21 du type de conductivité p- une région épitaxiale 20 de type de conductivité n comportant un certain nombre de régions de sous-collecteur 22 de type n+.

On a représenté sur la figure 5 le même élément après de nouvelles étapes de traitement. Une région d'isolement 23 constituée par exemple par un oxyde encastré, est formée dans la région épitaxiale. Par ailleurs afin d'établir un contact électrique externe avec la région de sous-collecteur enterrée 22, une région de traversée 24 de type n+ est réalisée par diffusion. Pratiquement cette structure est fabriquée en masquant la région 20, puis en procédant à un décapage et à une réoxydation de manière à former les régions 23. Ensuite, au moyen d'une étape de diffusion effectuée au travers des ouvertures appropriées d'un masque, on réalise la région 24. Ces étapes sont tout à fait classiques

11

dans ce domaine de la fabrication des circuits intégrés. Ainsi, la structure de la figure 5 se compose d'une région 20 dans laquelle peut être fabriqué un transistor semi-conducteur bipolaire, comportant un sous-collecteur enterré 22 associé à une région de traversée 24, l'ensemble étant entouré d'une région d'isolement 23.

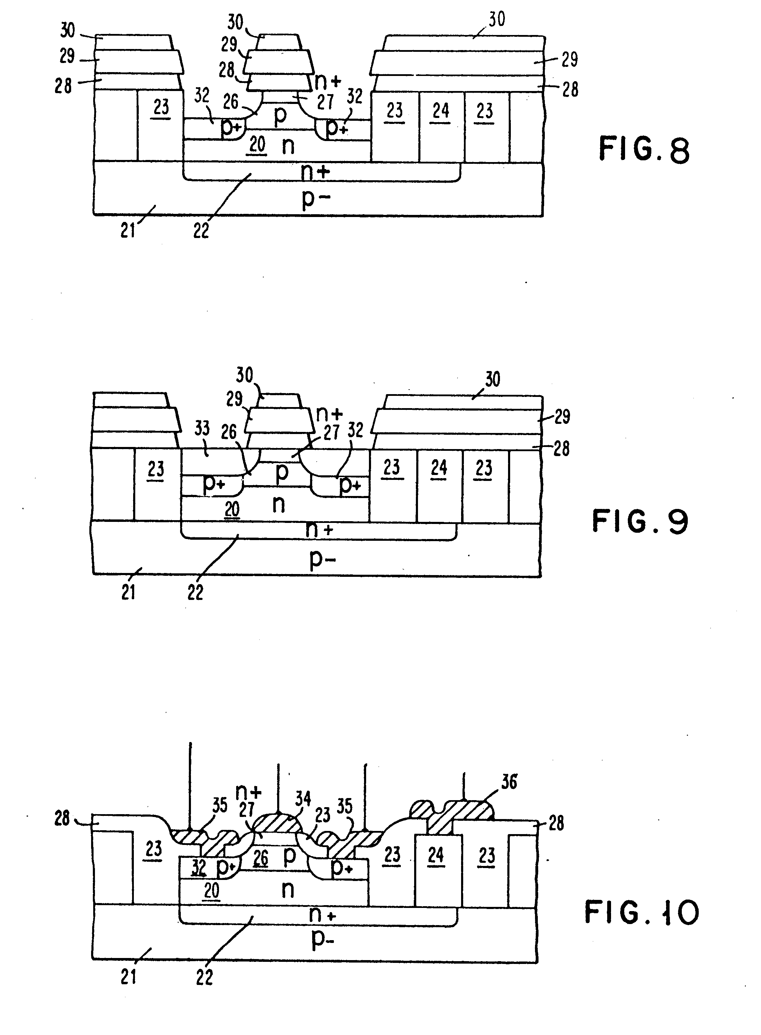

La structure représentée sur la figure 5 est d'abord recouverte d'une couche de masquage qui peut être constituée par un oxyde ou un photorésist 25, qui laisse seulement la région 20 exposée. A travers l'ouverture, la région 20 est convertie en une région de conductivité de type p et cette région, référencée 26, constituera la base du transistor. Des techniques classiques de diffusion ou d'implantation ionique peuvent être employées. On utilise ensuite une impureté du type n pour former la région ou couche 27 fortement dopée, dont une portion fera fonction d'émetteur. On pourra suivre la suite du procédé par référence à la figure 7.

Sur la figure 7, la couche de masquage 25 est alors retirée et remplacée par une couche de masquage ou de passivation 28 qui recouvre la totalité de la surface y compris la région 27. La couche 28 est recouverte d'une couche de masquage 29, en photorésist de préférence ou en nitrure de silicium. On applique ensuite une couche de masquage 30, puis une dernière couche 31 constituée par un photorésist de décapage. Ces couches permettront d'obtenir ultérieurement des ouvertures appropriées pour la réalisation du câblage électrique externe. Une ouverture est ensuite pratiquée

0004292

12

dans toutes les couches jusqu'à ce que la couche 27 soit exposée. Cette ouverture correspond à celle de l'étape 1 de la figure 1.

Comme le montre la figure 8, la région 27 est ensuite décapée de manière à produire un décapage latéral de la couche de masquage 28 à l'emplacement de l'émetteur et à délimiter la région 26 de façon à établir une jonction émetteur-base désirée entre les régions 27 et 26 avec des tolérances précises. La région 32, qui constituera la région de contact de base à faible résistivité, est ensuite formée par une implantation ionique effectuée au travers de l'ouverture. La région ainsi créée entoure donc complètement et symétriquement l'émetteur 27. Ce résultat peut être obtenu en implantant du bore de type de conductivité p. Cette étape correspond à l'étape 2 de la figure 1. ainsi cette réalisation préférée conduit à un transistor à base annulaire, dans lequel les régions émetteur et base sont concentriques.

Les régions de contact du dispositif peuvent à présent être passivées de la façon représentée sur la figure 9, par exemple en déposant de l'oxyde 33 sur la surface exposée des régions 32, 26 et 27.

On procède ensuite au décapage de la structure de manière à retirer les couches de masquage 29 et 30 et à laisser intact la couche de masquage 28 et la couche d'oxyde 33.

Une couche de photorésist est appliquée sur la couche d'oxyde de masquage 28 et des ouvertures destinées aux contacts de base, d'émetteur et de collecteur sont pratiquées dans cette couche. On élimine la couche 28

13

dans ces ouvertures. Le contact d'émetteur 34, le contact de base 35 et le contact de collecteur 36 sont ensuite formés par dépôt sous vide d'une couche de métal qui forme ces contacts dans les ouvertures, de façon classique (figure 10). La structure résultante est un transistor bipolaire isolé de type Mesa dont l'émetteur et la base sont auto-alignés.

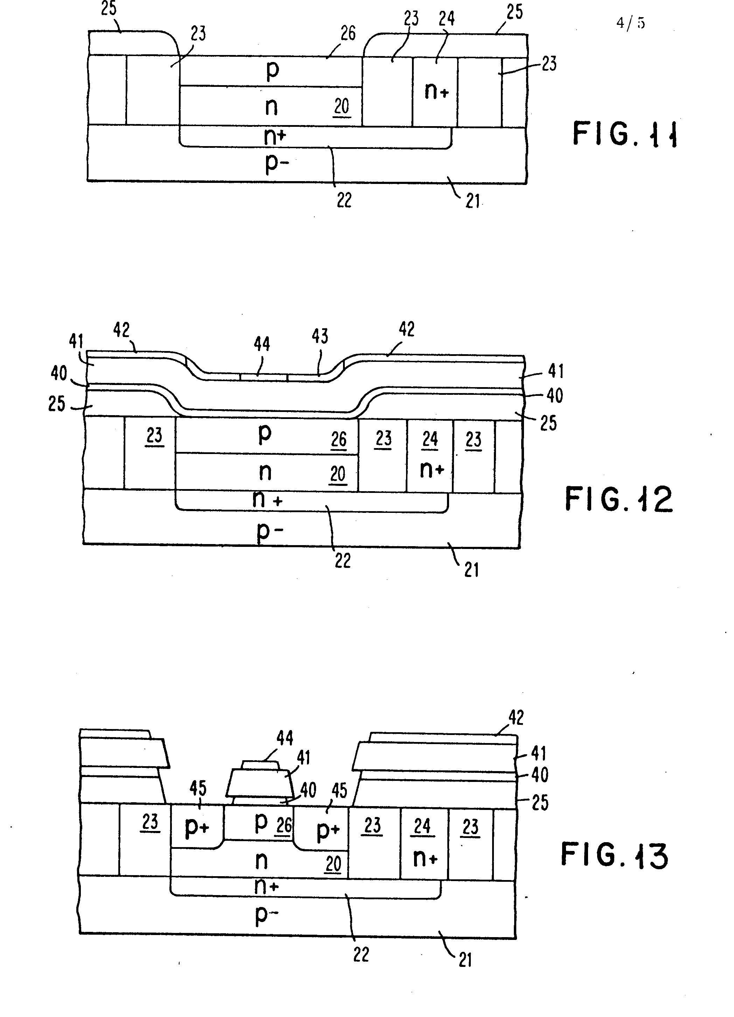

On décrira à présent un procédé légèrement différent dans lequel l'émetteur est formé par diffusion d'impuretés à partir d'un oxyde dopé. Ce deuxième procédé qui est également basé sur les étapes caractéristiques mentionnées sur la figure 1, est illustré au moyen des figures 11 à 15. Il utilise comme substrat semi-conducteur de départ celui représenté sur la figure 5.

Comme le montre la figure 11, une région 26 qui servira de région de base du transistor est formée par diffusion ou par implantation ionique au travers d'une couche de passivation ou de masquage en oxyde épais 25 présentant une ouverture appropriée.

Sur la figure 12, le masque en oxyde épais 25 restant en place, on réalise une mince couche d'oxyde 40 dopée avec de l'arsenic. Des couches de masquage 41 et 42 sont ensuite appliquées successivement. Une ouverture 43 est pratiquée dans la couche de masquage 42 en oxyde par exemple qui entoure la région 44 qui définira ultérieurement l'émetteur.

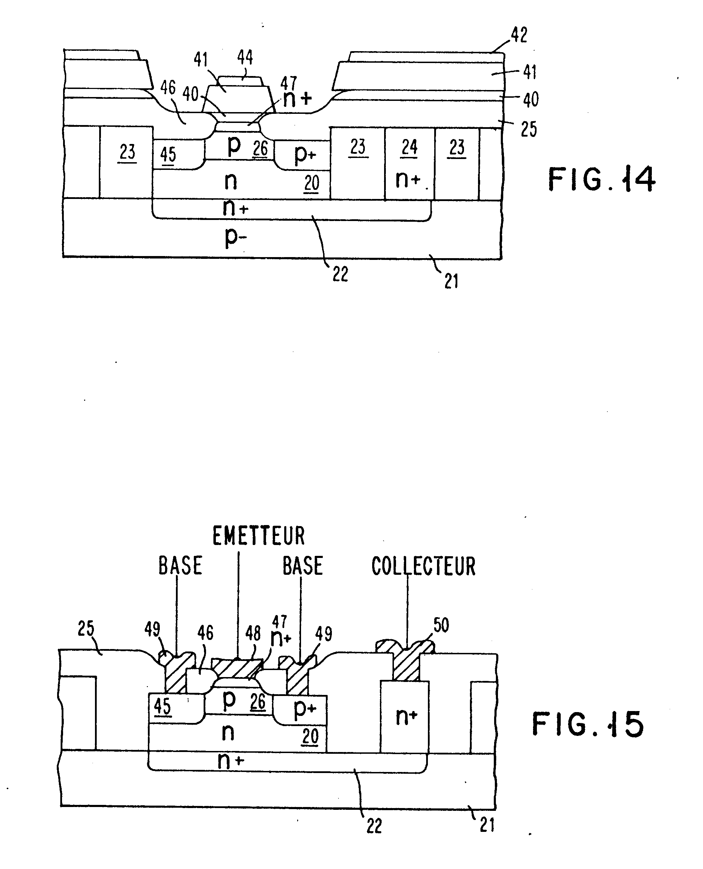

Comme le montre la figure 13, on procède ensuite à un décapage effectué au travers de l'ouverture 43 jusqu'à exposer la région 26. Il en résulte une couche de masquage composite présentant une ouverture autour de la portion de la couche d'oxyde 40 en contact avec la

14

région 26 qui permet de définir la région qui servira d'émetteur. Cette ouverture 43 correspond à celle mentionnée dans l'étape 1 de la figure 1. Sur la figure 13, une portion de la région 26 est transformée en région de contact de base fortement dopée 45 par une implantation ionique effectuée au travers de l'ouverture 43. Cette étape correspond à l'étape 2 de la figure 1.

L'étape suivante consiste à chauffer la structure dans une atmosphère oxydante. Cette étape permet de former l'oxyde 46 au-dessus des régions de base 45 et 26 et, simultanément, de provoquer une diffusion de l'arsenic à partir de l'oxyde 40 dans la région 26 et de transformer la conductivité d'une partie de cette région en une conductivité de type n, formant ainsi la région d'émetteur 47 (figure 14).

Comme le montre la figure 15, on procède ensuite à une étape de masquage et de décapage pour ouvrir les trous de contact dans les couches d'oxyde et exposer les régions de contact de base 45 et d'émetteur 47. Une nouvelle étape de masquage et de décapage permet de réaliser les contacts d'émetteur 48, de base 49 et de collecteur 50. Toutes ces étapes de fabrication sont classiques. La présente invention permet ainsi de réaliser des transistors bipolaires à régions base et émetteur annulaires et auto-alignées, facilement intégrables et très rapides. Ces transistors peuvent être utilisés dans les calculateurs.

Bien que l'on ait décrit dans ce qui précède et représenté sur les dessins les caractéristiques essentielles de l'invention appliquées à deux modes de réalisation

15

préférés de celle-ci, il est évident que l'homme de l'art peut y apporter toutes modifications de forme ou de détail qu'il juge utiles, sans pour autant sortir du cadre de ladite invention.

0004292

1

REVENDICATIONS

1. Procédé de fabrication d'une région de contact d'un transistor bipolaire de type Mesa dans un substrat semi-conducteur avec des régions base et émetteur auto-alignées caractérisé en ce que la couche de masquage qui définit la région d'émetteur sert également à délimiter la région de contact de base et la région de base.

2. Procédé de fabrication selon la revendication 1 caractérisé en ce qu'il comporte les étapes suivantes:

a) élaboration d'un substrat semi-conducteur comportant un support d'un premier type de conductivité (21), une région de sous-collecteur (22), une région de traversée de sous-collecteur (24), une couche épitaxiale d'un type de conductivité opposé (20) formant collecteur, des éléments d'isolement (23) définissant une poche isolée, une première couche dite de base (26) du premier type de conductivité,

b) formation d'une seconde couche du second type de résistivité (27) dite couche d'émetteur dans la couche de base,

2

c) formation d'une couche de masquage (28) selon une configuration désirée au-dessus de la couche d'émetteur, la partie sous-jacente de celle-ci définissant la région d'émetteur,

d) attaque des couches de base et d'émetteur à travers les ouvertures de la couche de masquage pour assurer la forme du type Mesa, la partie restante de la première couche constituant la région d'émetteur,

e) introduction d'un dopant du premier type de conductivité à travers ces ouvertures pour former la région de contact de base (32), qui est délimitée par ladite couche de masquage, cette étape délimite simultanément la région base,

f) formation de régions d'isolement sur les portions exposées de la région de contact de base, de la région base et de la région émetteur, et

g) formation des contacts électriques avec les régions émetteur, contact de base, et traversée de collecteur.

3. Procédé de fabrication selon la revendication 1 caractérisé en ce qu'il comporte les étapes suivantes:

a) élaboration d'un substrat semi-conducteur comportant un support d'un premier type de conductivité (21), une région de sous-collecteur

3

(22), une région de traversée de sous-collecteur (24), une couche épitaxiale d'un type de conductivité opposé (20) formant collecteur, des éléments d'isolement (23) définissant une poche isolée, une première couche dite de base (26) du premier type de conductivité,

b) formation d'une couche de masquage (40) en oxyde dopé par une impureté du deuxième type de conductivité selon une configuration désirée au-dessus de la couche de base,

c) introduction d'un dopant du premier type de conductivité à travers les ouvertures de la couche de masquage pour former la région de contact de base (45) qui est délimitée par la couche de masquage, cette étape délimite simultanément la région base,

d) attaque des parties exposées des régions de contact de base et de base,

e) formation des régions d'isolement (46) sur les parties exposées des régions de contact de base et de base et simultanément diffusion des impuretés de la couche de masquage dans la région base pour former une région émetteur (47),

f) formation des contacts électriques avec les régions émetteur, contact de base, et traversée de collecteur.

ETAPE 1 — REALISATION D'UNE OUVER-TURE DANS LA COUCHE DE MASQUAGE AUTOUR DE L'EMETTEUR.

ETAPE 2 — FORMATION D'UNE REGION DE CONTACT DE BASE QUI ENTOURE L'EMETTEUR

**FIG. 1**

**FIG. 2**

**FIG. 3**

FIG. 4

FIG. 5

FIG. 6

FIG. 7

FIG.8

FIG.9

FIG.10

FIG. 11

FIG. 12

FIG. 13

FIG.14

FIG.15